# EUROPÄISCHE PATENTSCHRIFT

(11) **EP 1 360 711 B1**
(45) Veröffentlichungstag und Bekanntmachung des Hinweises auf die Patenterteilung: **14.03.2007**
(21) Anmeldenummer: 02700152.8
(22) Anmeldetag: 17.01.2002
(51) Int. Cl.: H01L 21/033

(54) **HALBLEITERANORDNUNG UND VERFAHREN ZUR ÄTZUNG EINER SCHICHT DER HALBLEITERANORDNUNG MITTELS EINER SILIZIUMHALTIGEN ÄTZMASKE**
SEMICONDUCTOR ARRANGEMENT AND METHOD FOR ETCHING A LAYER OF SAID SEMICONDUCTOR ARRANGEMENT USING AN ETCHING MASK CONTAINING SILICON
ENSEMBLE SEMI-CONDUCTEUR ET PROCEDE POUR LA GRAVURE D'UNE COUCHE DE L'ENSEMBLE SEMI-CONDUCTEUR AU MOYEN D'UN MASQUE DE GRAVURE CONTENANT DU SILICIUM

(30) Priorität: 26.01.2001 DE 10103524
(43) Veröffentlichungstag der Anmeldung: 12.11.2003
(73) Patentinhaber: Infineon Technologies AG, 81669 München (DE)
(72) Erfinder: GOLDBACH, Matthias, 01099 Dresden (DE)
(74) Vertreter: Epping - Hermann - Fischer
(86) Internationale Anmeldenummer: PCT/DE2002/000130
(87) Internationale Veröffentlichungsnummer: WO 2002/059951

(56) Entgegenhaltungen:
- US-A- 3 510 369
- US-A- 4 782 009
- US-A- 5 240 554
- US-A- 6 025 273

## Beschreibung

Die vorliegende Anmeldung betrifft eine Halbleiteranordnung und ein Verfahren zur Ätzung einer Schicht der Halbleiteranordnung mittels einer siliziumhaltigen Ätzmaske.

Üblicherweise werden zur Strukturierung von Halbleitersubstraten Ätzverfahren verwendet. Dazu wird eine Ätzmaske auf eine zu strukturierende Schicht aufgebracht und mittels Photolithographie strukturiert. Einige Bereiche der zu strukturierenden Schicht werden nun durch die Ätzmaske abgedeckt und geschützt, wohingegen andere Bereich der zu ätzenden Schicht freiliegend sind. In einem nachfolgenden Ätzschritt wird die zu ätzende Schicht mittels eines Ätzmittels abgetragen. Dabei werden die von der Ätzmaske bedeckten Bereiche der zu ätzenden Schicht vor der Ätzsubstanz geschützt, so daß an diesen Positionen kein Ätzabtrag an der zu ätzenden Schicht erfolgt. Da bei dem Ätzvorgang sowohl die zu ätzende Schicht als auch die Ätzmaske der Ätzsubstanz ausgesetzt sind, werden beide Schichten abgetragen. Üblicherweise wird eine Ätzmaske mit einer hohen Selektivität gegenüber der zu ätzenden Schicht unter Verwendung des Ätzmittels gewählt. Dies bedeutet, daß der Ätzabtrag an der Ätzmaske wesentlich geringer ist als der Ätzabtrag an der zu ätzenden Schicht. Dadurch ist es möglich, mit relativ dünnen Ätzmasken tiefe Strukturen in die zu ätzende Schicht zu ätzen. Typische Materialien, die in der Siliziumhalbleitertechnologie verwendet werden, sind Silizium, Siliziumoxid und Siliziumnitrid. Mit einer geeigneten Ätzsubstanz ist jedes der drei Materialien dazu geeignet für eines oder beide der anderen Materialien als Ätzmaske verwendet zu werden.

Beispielsweise ist eine Ätzmaske aus Silizium dazu geeignet, in Verbindung mit einem fluorkohlenwasserstoffhaltigen Ätzgas Siliziumoxid bzw. Siliziumnitrid zu ätzen.

Es ist die Aufgabe der Erfindung, eine siliziumhaltige Ätzmaske beziehungsweise ein Verfahren mit der Verwendung einer siliziumhaltigen Ätzmaske so zu verbessern, daß die Ätzrate der siliziumhaltigen Ätzmaske verringert ist.

Diese Aufgabe wird gelöst durch eine Halbleiteranordnung mit einem Halbleitersubstrat mit einer Substratoberfläche, auf der eine Schicht angeordnet ist, die Siliziumoxid oder Siliziumnitrid enthält, die eine Oberfläche aufweist mit einer siliziumhaltigen Maskenschicht, die auf der Oberfläche der Schicht angeordnet ist, um für die Schicht als Ätzmaske zu dienen, wobei
die Maskenschicht zusätzlich eine schwefel- oder kohlenstoffhaltige Substanz enthält, wobei der Schwefel in einer Schwefel-Wasserstoff-Verbindung bzw. der Kohlenstoff in einer Kohlenwasserstoffkette vorliegt, wodurch die Ätzresistenz der Maskenschicht erhöht ist.

Die zusätzliche Substanz dient als Additiv in der Maskenschicht, wodurch die Ätzrate der siliziumhaltigen Maskenschicht reduziert wird. Dadurch ist in vorteilhafter Weise gewährleistet, daß die Ätzresistenz der siliziumhaltigen Maskenschicht durch die zusätzliche Substanz erhöht ist. Es können beispielsweise mit einer dünner ausgebildeten Maskenschicht tiefere Gräben in eine zu ätzende Schicht geätzt werden. Dies ist vorteilhaft, da eine dünne Maskenschicht mittels einer Photolithographie mit einer höheren Auflösung strukturiert werden kann als eine dicke Maskenschicht. Folglich ist die mittels der Maskenschicht übertragbare Strukturbreite verkleinert, was in vorteilhafter Weise zu kleineren und platzsparenden Bauelementen auf dem Halbleitersubstrat führt.

Eine Ausgestaltung der Erfindung sieht vor, daß die Substanz einen Anteil von bis zu 50% der Maskenschicht bildet.

Die Substanz bildet bei einem Druck zwischen 0.13 und 67 Pa und einer Temperatur zwischen -20°C und 200°C einen festen Stoff und als oxidiertes und/oder nitridiertes Molekül einen gasförmigen Stoff. Dies hat den Vorteil, daß die Substanz in dem angegebenen Temperaturbereich als feste Substanz in die Maskenschicht integriert werden kann und andererseits mittels Sauerstoff in eine gasförmige und somit flüchtige Form überführt werden kann, so daß die zusätzliche Substanz während des Ätzprozesses abtransportierbar ist.

Wird beispielsweise die siliziumhaltige Ätzmaske nahezu aus Silizium und die zu ätzende Schicht aus Siliziumoxid gebildet, so wird das Siliziumoxid mittels eines fluorkohlenwasserstoffhaltigen Ätzgases in Siliziumfluorid und Sauerstoff umgewandelt. Im Gegensatz zu Siliziumoxid wird die siliziumhaltige Maskenschicht zu einem wesentlich geringeren Teil durch die Ätzsubstanz angegriffen und umgewandelt. Dies wird darüber hinaus durch die zusätzliche Substanz reduziert. Ist die zusätzliche Substanz nun ebenfalls in der Nähe oder auf der zu ätzenden Siliziumoxidschicht angeordnet, so wird die zusätzliche Substanz durch den aus der Siliziumoxidschicht freiwerdenden Sauerstoff oxidiert und in eine flüchtige gasförmige Form umgewandelt. Dadurch wird die Ätzselektivität zwischen der siliziumhaltigen Ätzmaske und der zu ätzenden Siliziumoxidschicht erhöht.

Die Erfindung sieht vor, daß die Substanz Kohlenstoff in Form einer Kohlenwasserstoffkette oder Schwefel in Form von Schwefelwasserstoff enthält. Kohlenstoff und Schwefel sind in vorteilhafter Weise dazu geeignet, die Abtragsrate von mit Kohlenstoff oder Schwefel versetztem Silizium bei einem fluorkohlenwasserstoffhaltigen Ätzgas herabzusetzen.

Eine Ausgestaltung der Erfindung sieht vor, daß die Substanz Aluminium, Gallium, Indium, Thallium oder Bor in einer Konzentration mit mehr als 10¹⁹ Atomen pro cm³ enthält und elektrisch aktiviert ist. Elektrische aktiviert bedeutet, daß Bor auf Gitterplätzen des Si-Kristallgitters eingebunden ist. Die genannten Substanzen sind p-Dotierstoffe für die siliziumhaltige Maskenschicht. In vorteilhafte Weise weist eine p-dotierte Maskenschicht ebenfalls eines erhöhte Ätzresistenz auf.

Weiterhin ist vorgesehen, daß die zu ätzende Schicht Siliziumoxid oder Siliziumnitrid enthält.

Eine weitere Ausgestaltung der Erfindung sieht vor, daß die Substanz in die siliziumhaltige Maskenschicht implantiert ist.

Eine weitere Ausgestaltung der Erfindung sieht vor, daß die Substanz mittels Zuführung, während der Bildung der siliziumhaltigen Maskenschicht, in die siliziumhaltige Maskenschicht eingebaut ist.

Bezüglich des Verfahrens wird die Aufgabe gelöst durch ein Verfahren zur Ätzung einer Schicht eines Halbleitersubstrats mit einer siliziumhaltigen Ätzmaske mit den Schritten:
- Bilden einer Schicht, die Siliziumoxid oder Siliziumnitrid enthält, auf einem Substrat, wobei die Schicht eine Oberfläche aufweist;
- Bilden einer siliziumhaltigen Maskenschicht auf der Oberfläche der Schicht;
- Strukturieren der Maskenschicht, wobei eine Maskenstruktur gebildet wird;
- Ätzen der Schicht mit einem fluorkohlenwasserstoffhaltigen Ätzgas, in dem Kohlenwasserstoffmoleküle und/oder eine Schwefel-Wasserstoff-Verbindung enthalten sind, wobei die Ätzmaske die Oberfläche teilweise vor dem Ätzgas schützt.

Das erfindungsgemäße Verfahren führt Kohlenstoff und/oder Schwefel zusammen mit einem Ätzgas in eine Ätzanlage, wodurch die Ätzrate der siliziumhaltigen Ätzmaske verringert wird.

Eine Ausgestaltung des erfindungsgemäßen Verfahrens sieht vor, daß die in dem Ätzgas enthaltenen Kohlenwasserstoffmoleküle, die beispielsweise CH₄ enthalten, und/oder Schwefel-Wasserstoff-Verbindung, die beispielsweise SH₂ enthält, während des Ätzschritts in oder an der Maskenschicht angereichert werden. Die Anreicherung in oder an der Maskenschicht hat den Vorteil, daß die Ätzresistenz der siliziumhaltigen Ätzmaske erhöht und somit ihre Ätzrate herabgesetzt ist.

Ein weiterer vorteilhafter Verfahrensschritt sieht vor, daß die in dem Ätzgas enthaltenen Kohlenstoff und/oder Schwefelatome während des Ätzschrittes in oder an der Maskenschicht angereichert werden. Die Anreicherung von Kohlenstoff und/oder Schwefelatomen weist ebenfalls den Vorteil auf, daß die Ätzrate der siliziumhaltigen Maskenschicht herabgesetzt ist.

Weitere vorteilhafte Ausgestaltungen der Erfindung sind Gegenstand der jeweiligen Unteransprüche.

Nachfolgend wird die Erfindung anhand von Ausführungsbeispielen und Figuren näher erläutert.

In den Figuren zeigen:
- Figur 1: ein Substrat mit einer Schicht und einer Maskenschicht;
- Figur 2: eine Anordnung gemäß Figur 1, wobei die Schicht unter Zuhilfenahme der Maskenschicht strukturiert wurde;
- Figur 3: eine Darstellung der Ätzrate über dem Einfallswinkel des Ätzgases, mit und ohne zusätzliche Substanz.

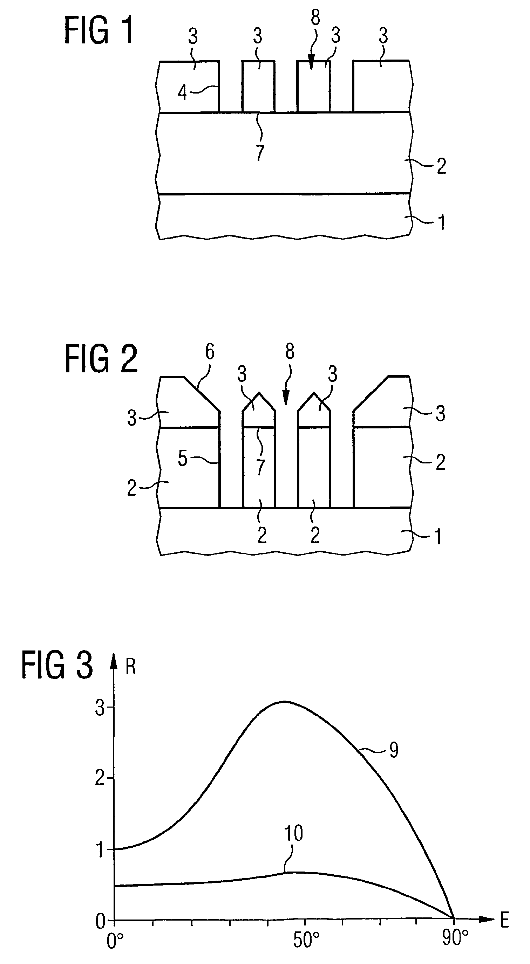

In Figur 1 ist ein Substrat 1 dargestellt, auf dem eine Schicht 2 angeordnet ist. Die Schicht 2 weist eine Oberfläche 7 auf, die dem Substrat 1 abgewandt ist. Auf der Oberfläche 7 der Schicht 2 ist eine Maskenschicht 3 angeordnet. Die Maskenschicht 3 ist so ausgebildet, daß sie eine Maskenstruktur 4 als Graben in der Maskenschicht 3 aufweist. Das Substrat 1 besteht beispielsweise aus einem siliziumhaltigen Material. Die Schicht 2 enthält Siliziumoxid und/oder Siliziumnitrid. Die Maskenschicht 3 enthält Silizium, wobei der Siliziumanteil bis zu 100% betragen kann.

Eine erste Variante sieht vor, daß in der siliziumhaltigen Maskenschicht 3 eine zusätzliche Substanz 8 enthalten ist. Bei der zusätzlichen Substanz handelt es sich beispielsweise um Kohlenstoff und/oder Schwefel. Die zusätzliche Substanz wird beispielsweise während der Bildung der Maskenschicht 3 zusammen mit der Maskenschicht 3 abgeschieden, wodurch die Substanz 8 in der Maskenschicht 3 eingebaut wird. Eine weitere Verfahrensvariante zur Bildung der Maskenschicht 3 bildet zunächst die Maskenschicht 3 ohne die zusätzliche Substanz 8. Anschließend wird die zusätzliche Substanz 8 beispielsweise mittels einer Implantation in die Maskenschicht 3 eingebracht.

Als weitere Materialien für die zusätzliche Substanz 8 sind beispielsweise p-Dotierstoffe wie Aluminium, Gallium, Indium, Thallium und Bor geeignet.

Anschließend wird die Schicht 2 entsprechend der in Figur 2 dargestellten Anordnung geätzt.

In Figur 2 ist die aus Figur 1 dargestellte Anordnung zu einem späteren Zeitpunkt dargestellt. Zunächst ist eine Ätzung mit einem fluorkohlenwasserstoffhaltigen Ätzgas durchgeführt worden, wobei in der Schicht 2 ein Graben 5 und an der Maskenschicht 3 eine Facette 6 gebildet wurde. Die Substanz 8 bewirkt zum einen, daß die Abtragsrate der Maskenschicht 2 reduziert ist und bewirkt insbesondere, daß die Abtragsrate am sich ausbildenden Facettenwinkel verringert wird. Dabei wird der Facettenwinkel zwischen der Substratoberfläche und der Facette 6 gemessen.

Ein weiteres Ausführungsbeispiel gemäß Figur 1 bildet zunächst die Maskenschicht 3 ohne die zusätzliche Substanz 8. Anschließend wird mit bezug auf Figur 2 die zusätzliche Substanz 8 dem Ätzgas beigemischt und bewirkt im Laufe des Ätzvorgangs die Erhöhung der Ätzselektivität, da sich die zusätzliche Substanz 8 in und/oder an der Maskenschicht 3 anreichert. Die Abtragsrate der Maskenschicht 3 wird dadurch reduziert. Während des Ätzvorgangs reichert sich die Substanz 8 in der Maskenschicht 3 an, wodurch die Ätzselektivität weiter gesteigert wird.

Mit Bezug auf das vorliegende Ausführungsbeispiel ist beispielsweise vorgesehen, daß die Schicht 2 eine Dicke von 1000 nm aufweist und aus Siliziumoxid und/oder Siliziumnitrid gebildet ist. Die Maskenschicht 3 kann beispielsweise mit einer Dicke von 100 nm aus Silizium gebildet sein und umfaßt zusätzlich die Substanz 8.

Die zusätzliche Substanz 8 bewirkt zum einen, daß die Abtragsrate der Maskenschicht 3 reduziert ist und insbesondere die Abtragsrate an dem sich ausbildenden Facettenwinkel erniedrigt wird.

In Figur 3 ist ein Diagramm dargestellt, welches auf der horizontalen Achse, die mit E bezeichnet ist, den Einfallswinkel E der Ätzsubstanz auf das Substrat in Grad (°) wiedergibt. Auf der vertikalen Achse, die mit R bezeichnet ist, ist die Ätzrate - normiert auf einen Einfallswinkel von 0° - aufgetragen. Eine erste Kurve 9 stellt beispielsweise die Ätzrate einer amorphen Siliziumschicht dar. Bei einem Einfallswinkel von 0° beträgt die normierte Abtragsrate 1. Die Abtragsrate steigt für Winkel zwischen 40° und 45° auf ein Maximum von ca. 3 an und fällt für größere Winkel ab, bis bei einem Einfallswinkel von 90° eine Abtragsrate von 0 erreicht ist. Hieraus folgt, daß bei senkrechtem Einfall der Ätzsubstanz auf eine strukturierte amorphe Siliziumschicht ein besonders schneller Ätzabtrag in Richtung eines 40° bis 45° Winkels stattfindet, wodurch ein sogenannter Taper entsteht, der die Facette 6 bildet. Die zweite Kurve 10 ist ebenfalls auf die Abtragsrate der ersten Kurve 9 bei einem Einfallswinkel von 0° normiert. Durch die zusätzliche Substanz 8 wird die Ätzrate auf einen Bruchteil der Ätzrate ohne zusätzliche Substanz herabgesetzt. Für größere Winkel steigt die Ätzabtragsrate auf ca. das 1,5 Fache bei einem Winkel von 55° an. Dies bedeutet, daß durch die zusätzliche Substanz 8 ein wesentlich schwächerer Taper-Effekt entsteht, wodurch die Facette 6 mit einem steileren Winkel und einer verringerten Abtragsgeschwindigkeit entstehen.

## Patentansprüche

1. Halbleiteranordnung, umfassend:
- ein Halbleitersubstrat (1) mit einer Substratoberfläche, auf der eine Schicht (2) angeordnet ist, die Siliziumoxid oder Siliziumnitrid enthält;
- mit einer siliziumhaltigen Maskenschicht (3), die auf einer Oberfläche (7) der Schicht (2) angeordnet ist, um für die Schicht (2) als Ätzmaske zu dienen, wobei
- die Maskenschicht (3) zusätzlich eine schwefel- oder kohlenstoffhaltige Substanz (8) enthält, wobei der Schwefel in einer Schwefel-Wasserstoff-Verbindung bzw. der Kohlenstoff in einer Kohlenwasserstoffkette vorliegt, wodurch die Ätzresistenz der Maskenschicht (3) erhöht ist.

2. Halbleiteranordnung nach Anspruch 1,
**dadurch gekennzeichnet, daß**
die Substanz (8) einen Anteil von bis zu 50% der Maskenschicht (3) bildet.

3. Halbleiteranordnung nach einem der Ansprüche 1 bis 2,
**dadurch gekennzeichnet, daß**
die Substanz (8) Aluminium, Gallium, Indium, Thallium oder Bor in einer Konzentration mit mehr als 10¹⁹ Atomen pro cm³ enthält.

4. Halbleiteranordnung nach einem der Ansprüche 1 bis 3,
**dadurch gekennzeichnet, daß**
die Substanz (8) in die siliziumhaltige Maskenschicht (3) implantiert ist.

5. Verfahren zur Ätzung einer Schicht einer Halbleiteranordnung mit einer siliziumhaltigen Ätzmaske nach einem der Ansprüche 1 bis 4 mit den Schritten:
- Bilden einer Schicht (2), die Siliziumoxid oder Siliziumnitrid enthält, auf einem Substrat (1), wobei die Schicht (2) eine Oberfläche (7) aufweist;
- Bilden einer siliziumhaltigen Maskenschicht (3) auf der Oberfläche (7) der Schicht (2);
- Strukturieren der Maskenschicht (3), wobei eine Maskenstruktur (4) gebildet wird;
- Ätzen der Schicht (2) mit einem fluorkohlenwasserstoffhaltigen Ätzgas, in dem Kohlenwasserstoffmoleküle und/oder einer Schwefel-Wasserstoff-Verbindung enthalten sind, wobei die Ätzmaske (3) die Oberfläche (7) teilweise vor dem Ätzgas schützt.

6. Verfahren nach Anspruch 5,
**dadurch gekennzeichnet, daß**
die in dem Ätzgas enthaltenen Kohlenwasserstoffmoleküle und/oder die Schwefel-Wasserstoff-Verbindung während des Ätzschritts in oder an der Maskenschicht (3) angereichert werden.

7. Verfahren nach einem der Ansprüche 5 oder 6,
**dadurch gekennzeichnet, daß**
die in dem Ätzgas enthaltenen Kohlenstoffatome und/oder Schwefelatome während des Ätzschrittes in oder an der Maskenschicht (3) angereichert werden.

## Claims

1. A semiconductor arrangement, comprising
- a semiconductor substrate (1) with a substrate surface on which a layer (2), which contains silicon oxide or silicon nitride is arranged;
- having a silicon-containing mask layer (3) which is arranged on a surface (7) of the layer (2) in order to be used as an etching mask for the layer (2), wherein
- the mask layer (3) additionally contains a sulphur- or carbon-containing substance (8), the sulphur being present in a sulphur-hydrogen compound and the carbon being present in a hydrocarbon chain, respectively with the result that the etching resistance of the mask layer (3) is increased.

2. The semiconductor arrangement according to Claim 1, **characterized in that** the substance (8) forms a fraction of up to 50% of the mask layer (3).

3. The semiconductor arrangement according to one of Claims 1 to 2, **characterized in that** the substance (8) contains aluminium, gallium, indium, thallium, or boron in a concentration of more than 10¹⁹ atoms per cm³.

4. The semiconductor arrangement according to one of Claims 1 to 3, **characterized in that** the substance (8) is implanted in the silicon-containing mask layer (3).

5. A method for etching a layer of a semiconductor arrangement using a silicon-containing etching mask as set forth in one of Claims 1 to 4, comprising the steps of:
- forming a layer (2), which contains silicon oxide or silicon nitride, on a substrate (1), the layer (2) having a surface (7);
- forming a silicon-containing mask layer (3) on the surface (7) of the layer (2);
- patterning the mask layer (3), during which process a mask pattern (4) is formed;
- etching the layer (2) using a fluorohydrocarbon-containing etching gas which contains hydrocarbon molecules and/or a sulphur-hydrogen compound, the etching mask (3) partially protecting the surface (7) against the etching gas.

6. The method according to Claim 5, **characterized in that** the sulphur-hydrogen compound and/or the hydrocarbon molecules contained in the etching gas are enriched in or on the mask layer (3) during the etching step.

7. The method according to one of Claims 5 or 6, **characterized in that** the sulphur atoms and/or carbon atoms contained in the etching gas are enriched in or on the mask layer (3) during the etching step.

## Revendications

1. Dispositif à semi-conducteurs comprenant :
- un substrat (1) semi-conducteur ayant une surface sur laquelle est disposée une couche (2) qui contient de l'oxyde de silicium ou du nitrure de silicium ;
- une couche (3) de masque contenant du silicium, qui est disposée sur une surface (7) de la couche (2) pour servir de masque d'attaque de la couche (2)
- la couche (3) de masque contient en outre une substance (8) soufrée ou carbonée, le soufre étant présent dans un composé soufré et hydrogéné et le carbone dans une chaîne d'hydrocarbonée, en sorte que la résistance à l'attaque de la couche (3) de masque est augmentée.

2. Dispositif à semi-conducteurs, suivant la revendication 1, **caractérisé en ce que** la substance (8) forme une proportion allant jusqu'à 50 % de la couche (3) de masque.

3. Dispositif à semi-conducteurs, suivant l'une des revendications 1 à 2, **caractérisé en ce que** la substance (8) contient de l'aluminium, du gallium, de l'indium, du thallium ou du bore en une concentration de plus de 10¹⁹ atomes par cm³.

4. Dispositif à semi-conducteurs, suivant l'une des revendications 1 à 3, **caractérisé en ce que** la substance (8) est implantée dans la couche (3) de masque contenant du silicium.

5. Procédé d'attaque d'une couche d'un dispositif à semi-conducteurs avec un masque d'attaque contenant du silicium, suivant l'une des revendications 1 à 4, comprenant les stades dans lesquels :
- on forme une couche (2) qui contient de l'oxyde de silicium ou du nitrure de silicium sur un substrat (1), la couche (2) ayant une surface (7),
- on forme une couche (3) de masque contenant du silicium sur la surface (7) de la couche (2),
- on structure la couche (3) de masque en formant ainsi une structure (4) de masque,
- on attaque la couche (2) par un gaz d'attaque fluoro-hydrocarboné dans lequel sont contenues des molécules hydrocarbonées et/ou un composé soufré et hydrogéné, le masque (3) d'attaque protégeant la surface (7) partiellement du gaz d'attaque.

6. Procédé suivant la revendication 5, **caractérisé en ce que** la couche (3) de masque s'enrichit en des molécules hydrocarbonées et/ou en le composé soufré et hydrogéné contenus dans le gaz, pendant le stade d'attaque.

7. Procédé suivant l'une des revendications 5 ou 6, **caractérisé en ce que** la couche (3) de masque s'enrichit en atomes de carbone et/ou en atomes de soufre contenus dans le gaz d'attaque pendant le stade d'attaque.
